# EUROPEAN PATENT APPLICATION

(11) **EP 3 474 334 A2**
(43) Date of publication of application: **24.04.2019**
(21) Application number: 18200510.8
(22) Date of filing: 15.10.2018
(51) Int. Cl.: H01L 31/18

(54) **LAYING DEVICE**

(30) Priority: 20.10.2017 CN 201721362097 U
(71) Applicant: Miasolé Equipment Integration (Fujian) Co., Ltd., 362005 Quanzhou Fujian (CN)
(72) Inventor: LIU, Lin, Quanzhou Fujian 362005 (CN); LI, Tao, Quanzhou Fujian 362005 (CN); YUAN, Qiang, Quanzhou Fujian 362005 (CN); ZENG, Jing, Quanzhou Fujian 362005 (CN); SUN, Shiyang, Quanzhou Fujian 362005 (CN); XU, Guojun, Quanzhou Fujian 362005 (CN); LIAN, Chongyan, Quanzhou Fujian 362005 (CN); HU, Binhua, Quanzhou Fujian 362005 (CN)
(74) Representative: Allain, Laurent

(57) **Abstract**

The present disclosure provides a laying device. The laying device includes: a fixing bracket (1), a weight pulley (3), and a working platform (5). With the laying device provided in the present disclosure, the weight pulley (3) provides a fixed pressing force for the sealing tape (2), and the position of the weight pulley (3) is set in advance, so that the sealing tape (2) is subjected to a suitable pressing force, and the pressing uniformity of the sealing tape (2) is good. Moreover, the weight pulley (3) is movable relative to the edge of the photovoltaic module (4) to be processed. Thus, for the photovoltaic module (4) to be processed whose edge is linear, the sealing tape (2) may be laid on the photovoltaic module (4) to be processed along a straight line, that is, it can be ensured that the sealing tape (2) is laid without bending.

## Description

This application claims priority to Chinese Patent Application No. 201721362097.6, filed with the State Intellectual Property Office on October 20, 2017 and titled "Device for Laying Edge Sealing Tape of Flexible Photovoltaic Module" the entire contents of which are incorporated herein by reference.

### TECHNICAL FIELD

The present disclosure relates to a laying device.

### BACKGROUND

Compared with a rigid photovoltaic module, a flexible photovoltaic module is light, thin, and flexible, and is used more widely. However, there are fewer manufacturers of the flexible photovoltaic module, and the relevant laying equipment is far from perfect, for example, the relevant equipment for laying an edge sealing tape of the flexible photovoltaic module is immature.

Currently, the edge sealing tape of the flexible photovoltaic module is laid mainly through manual operations. In the case of the manual operations, the sealing tape is fixed on the back board of the flexible photovoltaic module by a certain pressing force, and in this way, the laying of the sealing tape is achieved.

However, in the case of the manual operations, the manually applied pressing force is difficult to control. When the pressing force is too small, the adhesion force of the sealing tape is weak. When the release film is peeled off later, the tape will leave the back board, and the tape will be easily elongated to a certain degree. The width and thickness of the elongated tape cannot meet the requirements. When the pressing force is too great, air bubbles will occur after the module is laminated, and the pressing uniformity of the sealing tape is poor. Furthermore, in the case of the manual operations, it is difficult to ensure that the laid edge sealing tape is in a straight line, which affects the appearance and performance of the flexible photovoltaic module. In addition, the production efficiency of the manual operations is low.

### SUMMARY

The present disclosure provides a laying device for laying an edge sealing tape of a flexible photovoltaic module, the laying device comprising:
a working platform for supporting a photovoltaic module to be processed;
a fixing bracket for mounting a reel of sealing tape, the fixing bracket being located above the working platform; and
a weight pulley for pressing the sealing tape against the photovoltaic module to be processed, wherein the weight pulley is located above the working platform and is at a distance from the fixing bracket, and the weight pulley is movable relative to the edge of the photovoltaic module to be processed.

Optionally, the photovoltaic module to be processed is fixed on the working platform, a linear guide rail is provided on the ground, and the working platform is slidably connected to the linear guide rail.

Optionally, the working platform is fixed on the ground, and the photovoltaic module to be processed and the working platform are slidable relative to each other.

Optionally, the relative sliding between the photovoltaic module to be processed and the working platform is achieved by adding lubricating oil.

Optionally, the relative sliding between the photovoltaic module to be processed and the working platform is achieved by providing a roller.

Optionally, the photovoltaic module to be processed is fixed on the working platform, and the weight pulley is a moving pulley movable relative to the photovoltaic module to be processed.

Optionally, two fixing brackets and two weight pulleys are provided, and the two fixing brackets and the two weight pulleys are provided above and on opposite sides of the working platform, respectively.

Optionally, the bottom of the working platform is provided with legs, the bottom of the legs are provided with rollers; the rollers are provided in the linear guide rail, and the rollers are capable of reciprocating along the linear guide rail in the linear guide rail.

Optionally, the laying device according to claim further comprises a rotating platform for driving the linear guide rail and the working platform to be rotated together, wherein the rotating platform is provided between the linear guide rail and the ground.

Optionally, the laying device according further comprises an elevator device on which the weight pulley is mounted.

Optionally, the laying device according further comprises a limiting device for limiting the elevation height of the elevator device, wherein the limiting device is provided on the elevator device.

Optionally, the laying device according further comprises a position fixing device for positioning a photovoltaic module to be processed, wherein the position fixing device is provided on the working platform.

Optionally, the laying device according further comprises a positioning mechanism for positioning the working platform, wherein the positioning mechanism is provided on the linear guide rail.

Optionally, the laying device according further comprises a control mechanism for controlling the movement of the working platform, wherein the control mechanism is provided on at least one of the rollers.

Optionally, the laying device according further comprises a pressure detection device for detecting a pressing force applied to the sealing tape by the weight pulley, wherein the pressure detection device is provided on the weight pulley.

### BRIEF DESCRIPTION OF THE DRAWINGS

Fig. 1 is a structural diagram of a laying device according to one or more embodiments of the present disclosure;
Fig. 2 is a structural diagram of a laying device according to one or more embodiments of the present disclosure;
Fig. 3 is a top view of a laying sealing tape of a photovoltaic component to be processed according to one or more embodiments of the present disclosure;
Fig. 4 is a top view of a laying sealing tape of a photovoltaic component to be processed according to one or more embodiments of the present disclosure;
Fig. 5 is a structural diagram of a laying device according to one or more embodiments of the present disclosure;
Fig. 6 is a structural diagram of a laying device according to one or more embodiments of the present disclosure;
Fig. 7 is a structural diagram of a laying device according to one or more embodiments of the present disclosure; and
Fig. 8 is a structural diagram of a laying device according to one or more embodiments of the present disclosure.

### DETAILED DESCRIPTION

Hereinafter, the embodiments of the present disclosure will be described in detail. The embodiments are shown in the drawings. The same or similar numerals in the drawings denote the same or similar elements or elements having the same or similar function. The embodiments described with reference to the drawings are exemplary only, and are used to explain the present disclosure and cannot be construed as limiting the present disclosure.

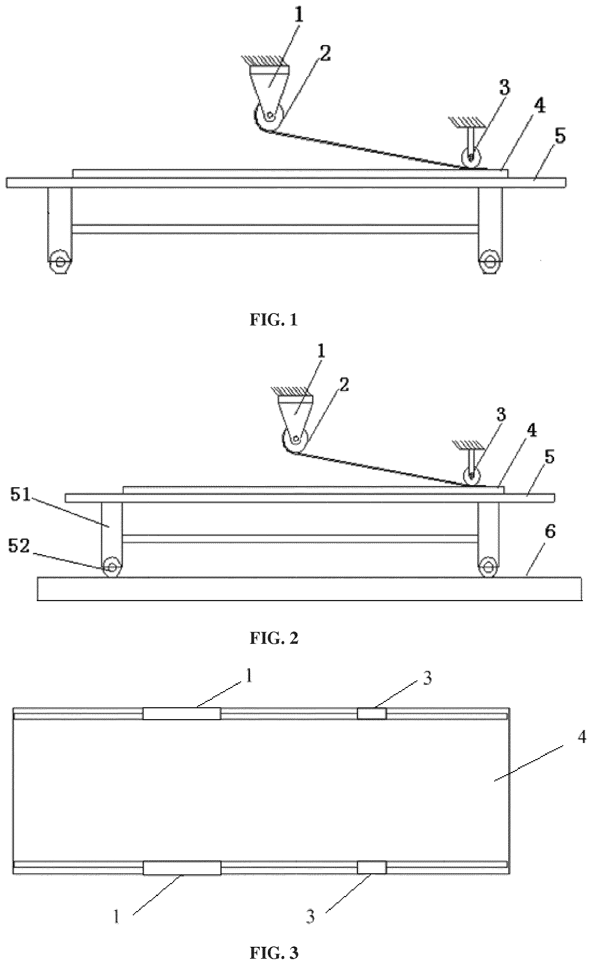

As shown in Fig. 1, an embodiment of the present disclosure provides a laying device for laying an edge sealing tape of a flexible photovoltaic module. The laying device includes: a working platform 5 for supporting a photovoltaic module 4 to be processed; a fixing bracket 1 located above the working platform 5, the fixing bracket 1 is used to mount a reel of sealing tape 2; a weight pulley 3 located above the working platform 5 and being at a distance from the fixing bracket 1, and the weight pulley 3 is movable relative to the edge of the photovoltaic module 4 to be processed, the weight pulley 3 is used to press the sealing tape 2 against the photovoltaic module 4 to be processed.

In operation, the fixing bracket 1 and the weight pulley 3 are generally fixed on the top of the operation workshop; and the sealing tape 2 is generally wound into a roll, and is mounted on the fixing bracket 1 through a rotating shaft so that the sealing tape 2 may be rotated relative to the fixing bracket 1. When the laying device is in operation, one end of the sealing tape 2 is stretched from the fixing bracket 1 to the photovoltaic module 4 to be processed. At this point, the weight pulley 3 and the sealing tape 2 on the photovoltaic module 4 to be processed are pressed against each other, so that the weight pulley 3 presses the sealing tape 2 against the photovoltaic module 4 to be processed.

In the embodiment of the present disclosure, the fixing method of the photovoltaic module 4 to be processed, the working platform 5 and the weight pulley 3 is different, and the implementing manner of the sealing tape thereof is also different.

Optionally, as shown in Fig. 2, the photovoltaic module 4 to be processed is fixed on the working platform 5. A linear guide rail 6 is provided on the ground, and the working platform 5 is slidably connected to the linear guide rail 6, that is, the working platform 5 brings the photovoltaic module 4 to be processed to be moved together along the linear guide rail 6, and the weight pulley 3 is not moved, so that the weight pulley 3 presses the sealing tape 2 against the photovoltaic module 4 to be processed. When the laying device is in operation, one end of the sealing tape 2 is stretched from the fixing bracket 1 to the photovoltaic module 4 to be processed, so that the weight pulley 3 and the sealing tape 2 on the photovoltaic module 4 to be processed are pressed against each other; an operator pushes the working platform 5, the weight pulley 3 and the rotating shaft rotate relative to each other, that is, the weight pulley 3 rotates clockwise, and the rotating shaft rotates counterclockwise, so that the sealing tape 2 is continuously supplied to achieve the laying thereof.

Optionally, the working platform 5 is fixed on the ground, and the photovoltaic module 4 to be processed and the working platform 5 are slidable relative to each other. When the laying device is in operation, the weight pulley 3 is not moved, and the operator controls the photovoltaic module 4 to be processed to slide on the working platform 5, it is thus achieved that the weight pulley 3 presses the sealing tape 2 against the photovoltaic module 4 to be processed. The weight pulley 3 may drive the rotating shaft to be rotated by the sealing tape 2, so that the sealing tape 2 is continuously supplied to achieve the laying thereof.

It should be noted that the relative sliding between the photovoltaic module 4 to be processed and the working platform 5 may be achieved directly through friction, or the relative sliding between the two may be achieved by adding lubricating oil, or the relative sliding between the two may be achieved by providing a roller between the two, which is not specifically limited in the embodiment of the present disclosure.

Optionally, the photovoltaic module 4 to be processed is fixed on the working platform 5; the weight pulley 3 is a moving pulley movable relative to the photovoltaic module 4 to be processed, that is, the movement of the weight pulley 3 is achieved through a top rail, a robot arm or other sliding devices, and the photovoltaic module 4 to be processed and the working platform 5 are not moved. When the laying device is in operation, the operator controls the weight pulley 3 to move in the direction in which the sealing tape 2 is laid. The weight pulley 3 drives the rotating shaft to be rotated by the sealing tape 2, so that the sealing tape 2 is continuously supplied to achieve the laying thereof.

With respect to the laying device according to the present disclosure, the gap between the weight pulley 3 and the working platform 5 is maintained when the sealing tape 2 is laid, so that the weight pulley 3 applies a fixed pressing force to the sealing tape 2. The gap between the weight pulley 3 and the working platforms 5 may be set before the laying of the sealing tape 2 according to actual needs, so that the sealing tape 2 is subjected to a suitable pressing force, and the pressing uniformity of the sealing tape 2 is good. Moreover, the weight pulley 3 is movable relative to the edge of the photovoltaic module 4 to be processed, so that for the photovoltaic module 4 to be processed whose edge is linear, the sealing tape 2 may be laid on the photovoltaic module 4 to be processed along a straight line, that is, it can be ensured that the sealing tape 2 is laid without bending. Through the cooperation of various components, the production efficiency of the flexible photovoltaic module may be greatly improved.

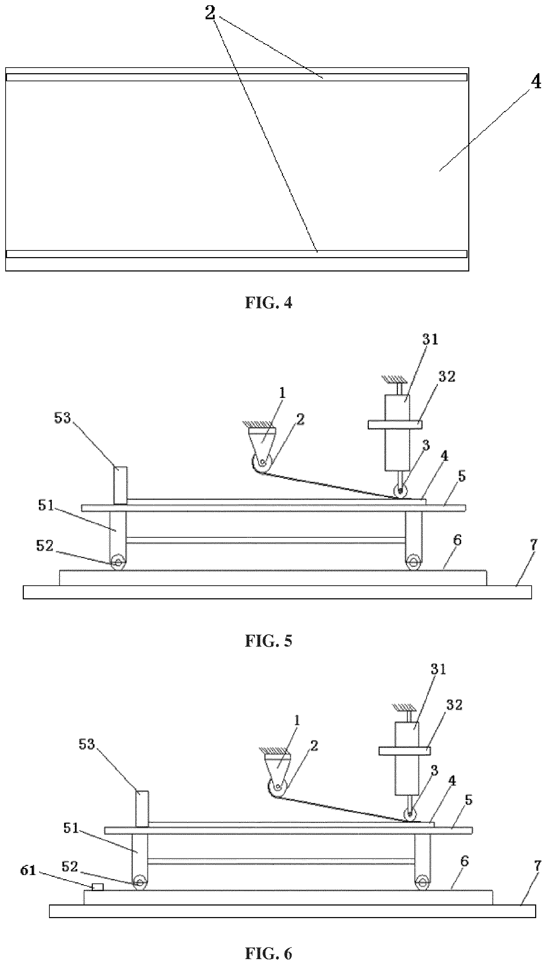

As shown in Fig. 3, two fixing brackets 1 and two weight pulleys 3 are provided, and the two fixing brackets 1 and the two weight pulleys 3 are provided above and on opposite sides of the working platform 5, respectively. The number and position of the fixing bracket 1 and the weight pulley 3 may be flexibly set according to actual needs. Generally, two fixing brackets 1 and two weight pulleys 3 are provided, and they are located above and on opposite sides or ends of the working platform 5. As shown in Fig. 4, it is convenient to press the sealing tape 2 against the opposite ends of the photovoltaic module 4 to be processed.

Optionally, as shown in Fig. 2, the bottom of the working platform 5 of the laying device is provided with legs 51, and the bottom of the legs 51 is provided with rollers. The rollers 52 are provided in the linear guide rail 6, and the rollers 52 are capable of reciprocating along the linear guide rail 6 in the linear guide rail 6.

As shown in Fig. 5, in some embodiments, the laying device further includes a position fixing device 53 provided on the working platform 5 for positioning the photovoltaic module 4 to be processed laid on the working platform 5. The position fixing device 53 may be implemented in a variety of ways, such as a limiting rod or a limiting frame, which is not limited in the present disclosure, as long as the position fixing device 53 can position the photovoltaic device 4 to be processed.

As shown in Fig. 5, in some embodiments, the laying device further includes an elevator device 31 on which the weight pulley 3 is mounted. The elevator device 31 is connected to the weight pulley 3 for driving the weight pulley 3 to change the elevation position. The elevator device 31 may be implemented in a variety of ways, such as a hydraulic cylinder and a spring, which is not limited in the present disclosure, as long as the elevator device 31 can drive the weight pulley 3 to change the elevation position.

As shown in Fig. 5, in some embodiments, the laying device further includes a limiting device 32 provided on the elevator device 31 for limiting the elevation height of the elevator device 31. The limiting device 32 may be implemented in a variety of ways, such as a solenoid valve, a fixing rod inserted in the elevator device 31, which is not limited in the present disclosure, as long as the limiting device 32 can limit the elevation height of the elevator device 31. It should be noted that when the elevator device 31 is raised and lowered, the limiting device 32 can stop the elevator device 31 at any time.

As shown in Fig. 5, in some embodiments, the laying device further includes a rotating platform 7 provided between the linear guide rail 6 and the ground. The rotating platform 7 can drive the linear guide rail 6 and the working platform 5 to be rotated together.

In some embodiments, as shown in Fig. 6, the laying device further includes a positioning mechanism 61 for positioning the working platform 5. The positioning mechanism 61 is provided on the linear guide rail 6. The positioning mechanism 61 facilitates stopping the working platform 5 when the working platform 5 reciprocates on the linear guide rail 6. For example, the positioning mechanism 61 may be a clip.

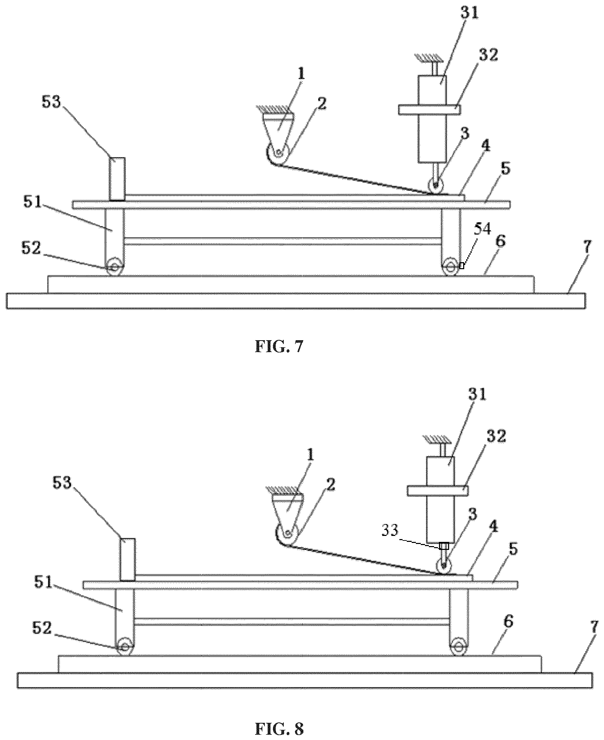

Optionally, as shown in Fig. 7, the laying device further includes a control mechanism 54 for controlling the movement of the working platform 5. The control mechanism 54 is provided on at least one of the rollers 52. It should be noted that the control mechanism 54 may be provided on each of the rollers 52, or the control mechanism 54 may be provided on one or more of the rollers 52, which is not limited in the embodiment of the present disclosure.

Optionally, as shown in Fig. 8, the laying device further includes a pressure detection device 33 for detecting the pressing force applied to the sealing tape 2 by the weight pulley 3. The pressure detection device 33 is provided on the weight pulley 3.

Optionally, the pressure detection device 33 is connected to the surface of the weight pulley 3 for detecting the pressing force applied to the sealing tape 2 by the weight pulley 3. The pressure detection device 33 may be implemented in a variety of ways, such as a pressure detection probe, a pressure gauge, which is not limited in the present disclosure, as long as the pressure detection device 33 can detect the pressing force applied to the sealing tape 2 by the weight pulley 3. Using the pressure detection device 33 to detect the pressing force applied to the sealing tape 2 by the weight pulley 3, it is convenient for the operator to flexibly adjust the pressing force.

The embodiment of the present disclosure provides an example in which the laying is performed using the laying device. In this example, the working platform 5 of the present disclosure may be an ordinary moving table. The working steps are as follows:
1. The moving table is moved to its original position, the photovoltaic back board (the photovoltaic module 4 to be processed) is placed on the moving table (the working platform 5), the starting end of the edge sealing tape 2 is pulled out from the fixing bracket 1 and fixed at a specified position on the photovoltaic back board (the edge sealing tape 2 should be located directly below the weight pulley 3).
2. The operator pushes the moving table forward in the direction of the linear guide rail 6, so that the weight pulley 3 presses the sealing tape 2 against the photovoltaic module 4 to be processed and stops at the location where the photovoltaic module 4 to be processed is previously positioned.
3. The sealing tape 2 is manually cut at the positioned location to complete the laying of the sealing tape 2. Since two sets of the sealing tape 2, the fixing bracket 1 and the weight pulley 3 of the laying device may be provided side by side in the left-right direction, two sealing tapes 2 may be laid at the same time.

In summary, with respect to the laying device according to the present disclosure, the weight pulley provides a fixed pressing force for the sealing tape, and the position of the weight pulley may be manually set in advance, so that the sealing tape is subjected to a suitable pressing force, and the pressing uniformity of the sealing tape is good. Moreover, the weight pulley is movable relative to the edge of the photovoltaic module to be processed. Thus, for the photovoltaic module to be processed whose edge is linear, the sealing tape may be laid on the photovoltaic module to be processed along a straight line, that is, it can be ensured that the sealing tape is laid without bending, which ensures the appearance and performance of the photovoltaic module to be processed. Through the cooperation of various components, the production efficiency may be greatly improved.

The structures, characteristics and effects of the present disclosure are explained in detail according to the embodiments as shown in the drawings. The forgoing is merely preferred embodiments of the present disclosure. However, the implementing scope of the present disclosure is not limited by the drawings. All changes made according to the conception of the present disclosure or the equivalent embodiments with equivalent modifications should still belong to the protective scope of the present disclosure when not going beyond the spirit covered by the description and the drawings.

## Claims

1. A laying device for laying an edge sealing tape of a flexible photovoltaic module, the laying device comprising:
a working platform (5) for supporting a photovoltaic module (4) to be processed;
a fixing bracket (1) for mounting a reel of sealing tape (2), the fixing bracket (1) being located above the working platform (5); and
a weight pulley (3) for pressing the sealing tape (2) against the photovoltaic module (4) to be processed, wherein the weight pulley (3) is located above the working platform (5) and at a distance from the fixing bracket (1), and the weight pulley (3) is movable relative to the edge of the photovoltaic module (4) to be processed.

2. The laying device according to claim 1, wherein the photovoltaic module (4) to be processed is fixed on the working platform (5), a linear guide rail (6) is provided on the ground, and the working platform (5) is slidably connected to the linear guide rail (6).

3. The laying device according to claim 1, wherein the working platform (5) is fixed on the ground, and the photovoltaic module (4) to be processed and the working platform (5) are slidable relative to each other.

4. The laying device according to claim 3, wherein the relative sliding between the photovoltaic module (4) to be processed and the working platform (5) is achieved by adding lubricating oil.

5. The laying device according to claim 3, wherein the relative sliding between the photovoltaic module (4) to be processed and the working platform (5) is achieved by providing a roller.

6. The laying device according to claim 1, wherein the photovoltaic module (4) to be processed is fixed on the working platform (5), and the weight pulley (3) is a moving pulley movable relative to the photovoltaic module (4) to be processed.

7. The laying device according to claim 1, wherein two fixing brackets (1) and two weight pulleys (3) are provided, and the two fixing brackets (1) and the two weight pulleys (3) are provided above and on opposite sides of the working platform (5), respectively.

8. The laying device according to claim 2, wherein the bottom of the working platform (5) is provided with legs (51), the bottom of the legs (51) are provided with rollers (52); the rollers (52) are provided in the linear guide rail (6), and the rollers (52) are capable of reciprocating along the linear guide rail (6) in the linear guide rail (6).

9. The laying device according to claim 2, further comprising a rotating platform (7) for driving the linear guide rail (6) and the working platform (5) to be rotated together, wherein the rotating platform (7) is provided between the linear guide rail (6) and the ground.

10. The laying device according to claim 1, further comprising an elevator device (31) on which the weight pulley (3) is mounted.

11. The laying device according to claim 10, further comprising a limiting device (32) for limiting the elevation height of the elevator device (31), wherein the limiting device (32) is provided on the elevator device (31).

12. The laying device according to claim 1, further comprising a position fixing device (53) for positioning a photovoltaic module (4) to be processed, wherein the position fixing device (53) is provided on the working platform (5).

13. The laying device according to claim 2, further comprising a positioning mechanism (61) for positioning the working platform (5), wherein the positioning mechanism (61) is provided on the linear guide rail (6).

14. The laying device according to claim 8, further comprising a control mechanism (54) for controlling the movement of the working platform (5), wherein the control mechanism (54) is provided on at least one of the rollers (52).

15. The laying device according to any of claims 1 to 14, further comprising a pressure detection device (33) for detecting a pressing force applied to the sealing tape (2) by the weight pulley (3), wherein the pressure detection device (33) is provided on the weight pulley (3).
